Europäisches Patentamt

European Patent Office

Office européen des brevets

(11) Numéro de publication: **0 075 368**
**B1**

(12) **FASCICULE DE BREVET EUROPEEN**

(45) Date de publication du fascicule du brevet: **01.06.88**

(21) Numéro de dépôt: **82201147.4**

(22) Date de dépôt: **16.09.82**

(51) Int. Cl.⁴: **H 01 L 21/76,** H 01 L 21/265,
H 01 L 21/324

(54) **Procédé de fabrication d'un dispositif semi-conducteur en GaAs par implantations ioniques, ainsi que substrat et dispositif ainsi obtenus.**

(30) Priorité: **18.09.81 FR 8117664**

(43) Date de publication de la demande:
**30.03.83 Bulletin 83/13**

(45) Mention de la délivrance du brevet:
**01.06.88 Bulletin 88/22**

(84) Etats contractants désignés:
**DE FR GB IT**

(56) Documents cités:
**FR-A-2 180 540
FR-A-2 358 751**

**TECHNICAL DIGEST OF THE INTERNATIONAL
ELECTRON DEVICES MEETING, Washington,
D.C., 8-10 décembre 1980, pages 398-400, IEEE,
New York; USA, H.T. YUAN et al.: "GaAs
bipolar integrated circuit technology"
ELECTRONICS LETTERS, vol. 14, no. 10, mai
1978, pages 306-308, Hitchin Herts, GB., S.
GECIM et al.: "Carrier removal profiles from
oxygen implanted GaAs"**

(73) Titulaire: **Laboratoires d'Electronique et de
Physique Appliquée L.E.P.
3, Avenue Descartes
F-94450 Limeil-Brévannes (FR)**
(84) **FR**

(73) Titulaire: **N.V. Philips' Gloeilampenfabrieken
Groenewoudseweg 1
NL-5621 BA Eindhoven (NL)**
(84) **DE GB IT**

(72) Inventeur: **Berth, Michel Société Civile S.P.I.D.
209 rue de L'Université
F-75007 Paris (FR)**
Inventeur: **Venger, Camille Société Civile S.P.I.D.
209 rue de L'Université
F-75007 Paris (FR)**
Inventeur: **Gérard, Marie Martin Société Civile
S.P.I.D.
209 rue de l'Université
F-75007 Paris (FR)**

(74) Mandataire: **Landousy, Christian et al
Société Civile S.P.I.D. 209, Rue de l'Université
F-75007 Paris (FR)**

Courier Press, Leamington Spa, England.

(58) References cited:

**ELECTRONICS LETTERS, vol. 17, no. 23, 12 novembre 1981, pages 873-874, Hitchin Herts, GB., M. BERTH et al.: "Selective carrier removal using oxygen implantation in GaAs"**
**JOURNAL OF APPLIED PHYSICS, vol. 47, no. 6, juin 1976, pages 2532-2536, New York, USA, P.N. FAVENNEC: "Semi-insulating layers of GaAs by oxygen implantation"**

## Description

L'invention concerne un procédé de fabrication d'un dispositif semiconducteur comportant un corps semiconducteur en arséniure de gallium (GaAs), dans lequel un substrat semi-isolant d'arséniure de gallium est pourvu sur une face d'une couche d'arséniure de gallium de type de conductivité N, après quoi, des régions d'isolement sont formées, lesdites régions d'isolement s'étendant au moins jusqu'à la région du substrat semi-isolant et divisant ladite couche d'arséniure de gallium en des îlots mutuellement isolés, îlots dans lesquels des éléments de circuit semiconducteur sont formés, ladite couche d'arséniure de gallium de type de conductivité N étant formée par une implantation d'ions sur l'entière surface du substrat semi-isolant et lesdites régions d'isolement étant formées ensuite par une opération sélective, le corps semiconducteur étant soumis à un traitement thermique après l'implantation.

L'invention a trait au domaine de l'électronique, plus spécifiquement aux technologies de fabrication des dispositifs semiconducteurs.

Il est connu de l'état de la technique et notamment de l'article de R. G. Hunsperger et N. Hirsch intitulé "GaAs Field-Effect Transistors with ion-implanted channels" publié dans "Electronics Letters, Vol. 9, 13—12—1973, pages 577—578" un procédé de fabrication d'un transistor à effet de champ comportant la réalisation d'une couche de type N sur un substrat semi-isolant en arséniure de gallium GaAs par l'implantation d'ions soufre (S) pour former la région de canal, et comportant la formation de régions d'isolement pour isoler un îlot de cette couche de type N sur lequel est constitué le transistor à effet de champ. Conformément au procédé décrit, ces régions d'isolement sont obtenues par une structure MESA.

Il est également connu de l'état de la technique et notamment de l'article de P. N. Favenec intitulé "Semi-Insulating layers of GaAs by Oxygen implantation" publié dans "Journal of Applied Physics, Vol. 47, N° 6, 6—1976, pages 2532—2536" l'action de l'ion d'oxygène implanté dans un substrat d'arséniure de gallium GaAs. Ce document enseigne que dans un substrat massif de GaAs, dopé lors du tirage au moyen des ions Sn-, Si-, Se-, ou Te-, des couches semi-isolantes peuvent être obtenues par implantation d'oxygène non localisée suivie d'un recuit. Ce document enseigne en outre que le comportement de l'ion oxygène pour obtenir ce résultat est indépendant de l'élément dopant choisi parmi le groupe cité.

En vue d'obtenir une conductivité de type N dans un substrat de GaAs, parmi les différents implants possibles répertoriés dans la liste suivante Si, Se, S, et Te, la Demanderesse a été conduite à sélectionner le silicium pour les raisons suivantes:

— l'ion tellure (Te) est trop gros et son implantation provoque des dommages trop importants dans la matrice cristalline, — l'ion soufre (S) diffuse trop lors du recuit ultérieur. Le choix s'est donc réduit à Si et Se.

D'autre part, l'invention visant à fournir un procédé de réalisation fiable et peu complexe dont la mise en oeuvre par un industriel n'obère pas ses coûts de fabrication, et une double implantation s'avérant un procédé particulièrement simple, la Demanderesse a mené différentes expériences qui ont révélé l'effet surprenant selon lequel le couple d'implants (Si—O) est sensiblement cent fois plus efficace que le couple d'implants (Se—O) pour obtenir un effet d'isolation. C'est-à-dire qu'il faut une dose cent fois moins importante d'oxygène pour obtenir le même degré d'isolation lorsque l'implantation d'oxygène est réalisée à la suite d'une implantation de Si, que lorsque cette implantation d'oxygène est réalisée à la suite d'une implantation de Se.

Le but visé par l'invention est donc atteint au moyen du procédé décrit dans le préambule, caractérisé en ce que les ions de dopage de la couche N sont des ions de silicium, en ce que les régions d'isolement sont formées par implantation d'ions d'oxygène, et en ce que le traitement thermique a lieu après la formation des régions d'isolement.

De cette manière, on peut procéder d'une façon très simple et surtout automatisée au relevé du profil C(V) en plusieurs points de la plaquette ainsi traitée (cartographie) après la première implantation ionique et s'assurer de façon globale de la conformité de ladite plaquette aux exigences préalablement définies, et le cas échéant, de rejeter la plaquette, alors que le coût de traitement de celle-ci n'est pas encore très élevé.

La description qui va suivre en regard des dessins annexés, donnés à titre non limitatif, permettra de mieux comprendre comment l'invention s'exécute et se poursuit.

La figure 1 représente un accélérateur ionique dit de Van de Graaf, pour implantation.

Les figures 2 à 6 représentent diverses étapes du procédé selon la présente invention, et des opérations de mesures à effectuer.

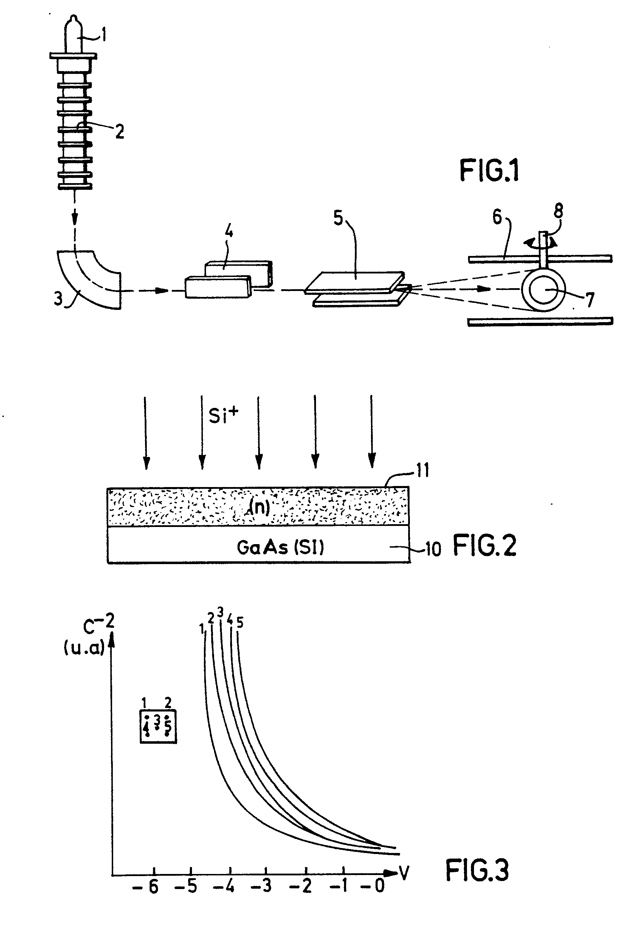

Le dispositif, tel que représenté à la figure 1, représente un accélérateur ionique de Van de Graaf utilisé de façon usuelle pour implantation ionique dans des plaquettes de divers matériaux, et notamment des plaquettes de semiconducteurs.

Un tel dispositif comporte généralement une source d'ions 1, des moyens électrostatiques 2 pour accélérer ceux-ci, des moyens 3 pour séparer les diverses espèces ioniques présentes dans le faisceau, des moyens 4 ou 5 pour faire dévier dans un plan horizontal ou vertical les ions ainsi sélectionnés, enfin une fenêtre 6, de façon à pouvoir visualiser, disposer et déplacer un substrat 7 sur un porte-substrat 8.

Lorsqu'un ion est accéléré par une importante différence de potentiel, dans un accélérateur tel que celui représenté à la figure 1, et qu'il pénètre à travers la surface d'une plaquette, un grand nombre d'effets s'ensuivent.

D'une part, il vient se localiser de façon aléatoire dans la matrice cristalline de la plaquette à des profondeurs qui dépendent de son énergie cinétique, des dimensions respectives de l'implant et des atomes de la matrice d'accueil et qui peuvent être déterminées de façon statistique par les tables de Lindhard, Scharff et Schiott, (Hansted Press, Division of John WINLEY and Sons Inc.), qui donnent les paramètres de la distribution gaussienne, courbe théorique du profil d'implantation.

D'autre part, la présence d'atomes étrangers vient modifier de façon sensible les propriétés de conductivité électrique de la plaquette, notamment lorsqu'il s'agit d'un matériau semiconducteur. Ainsi, par exemple, l'implantation dans une plaquette semi-isolante de GaAs, d'ion silicium ($Si^+$) ou sélénium ($Se^+$), en quantités suffisantes, la rend conductive, de type de conductivité n, alors que l'implantation d'ions béryllium ($Be^+$) la rend conductive, de type de conductivité p.

Le procédé de traitement selon la présente invention sera décrit, en référence aux figures 2 à 6, dont les éléments identiques portent les mêmes nombres.

A partir d'une plaquette d'arséniure de gallium, telle que référencée 10 à la figure 1, de type semi-isolant, obtenue par exemple par un dopage initial au chrome lors de l'élaboration, par exemple selon le procédé BRIDGMAN, on implante uniformément sur l'entière surface 11 de la plaquette des ions silicium ($Si^+$) avec un faisceau ionique dont le flux est compris sensiblement entre $10^{12}$ et $5.10^{12}$ $cm^{-2}$, et une énergie cinétique de 50 à 500 keV, ce qui donne une profondeur de pénétration théorique calculée à partir des valeurs tabulées de LSS, comprise entre 0,1 et 1 micromètre ($\mu m$).

Il est alors possible d'effectuer un relevé des profils C(V) (Figure 3) à partir d'une méthode parfaitement connue et automatisée telle que la technique de la double bille de mercure, décrite par exemple dans Electronics Letters, 11, 580 (1975) dans l'article "Fast and non-destructive method of C(V) profiling of thin semiconductor layer, on an insulating substrate" par M. BINET.

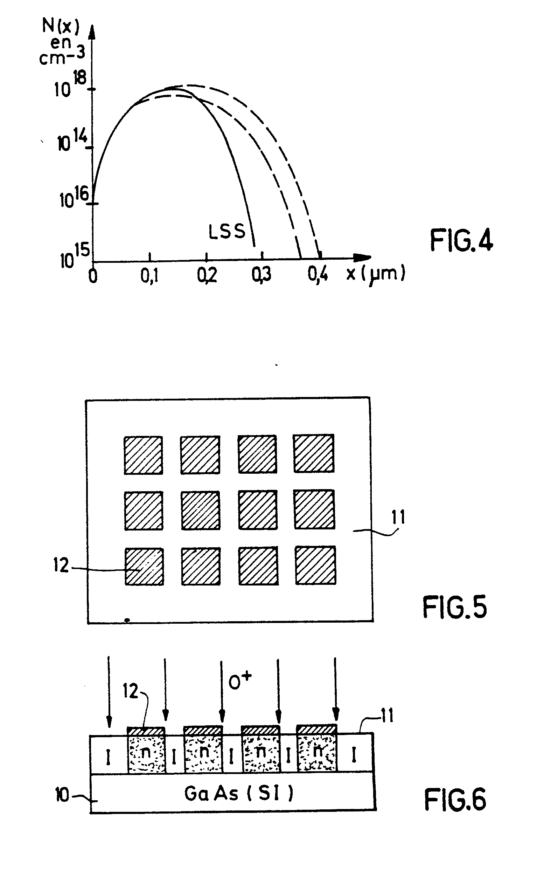

A partir de ces relevés cartographiques des caractéristiques capacité-tension, on en déduit les profils de dopage correspondants (Figure 4), c'est-à-dire la densité de porteurs libres N(x) (en $cm^{-3}$), en fonction de la profondeur, qui s'écarte quelque peu de la gaussienne théorique calculée.

Après ce test simple et peu coûteux, on est alors conduit à rejeter la plaquette comme non conforme (inhomogénéité, densité de porteurs libres trop faible...), ou de la conserver, alors qu'en outre, on peut en déduire avec une bonne approximation le flux auquel elle doit être soumise lors des prochains bombardements ioniques.

L'étape suivante du procédé, telle que représentée à la figure 5, consiste à réaliser un masquage partiel à partir d'une laque photosensible 12, d'une épaisseur moyenne de l'ordre du micromètre selon une technique connue en soi de photogravure.

On implante ensuite des ions oxygène ($0^+$) avec une dose environ dix fois plus importante, comprise sensiblement entre $10^{13}$ et $5.10^{13}$ $cm^{-2}$, et une énergie comprise entre 50 et 500 keV. Aux endroits non recouverts de laque, l'implantation d'ions oxygène à ces doses va rendre isolante la région implantée, et l'on obtiendra par exemple une structure telle que représentée à la figure 6 où sont séparées par des régions isolantes (I), des régions de type de conductivité n pour la fabrication, sur une même plaquette, d'une multitude de cellules élémentaires.

Un tel procédé de réalisation peut ainsi conduire à une densité d'intégration très grande, de telle sorte que l'on peut obtenir des circuits intégrés à grande échelle (dits LSI, de l'anglais "Large scale integration"), avec des complexités de circuit supérieures à 100 portes-logiques par plaquette.

L'étape ultérieure du procédé consiste à effectuer un traitement thermique de façon à activer la couche (pour faire passer les atomes implantés d'une position intersticielle à une position substitutionnelle dans la matrice cristalline d'accueil) et à guérir les défauts occasionnés par le bombardement. Ce traitement thermique s'effectue à des températures de l'ordre de 700°C à 900°C pendant une quinzaine de minutes et de préférence sous encapsulant, de façon à éviter l'évaporation des composants du cristal (spécialement l'arsenic). Divers encapsulants sont possibles, tels que l'alumine ($Al_2O_3$), la silice ($SiO_2$) ou le nitrure de silicium ($Si_3N_4$) ... préférentiellement, la Demanderesse utilise ce dernier avec une épaisseur de quelques dizaines de nanomètres, obtenue par réaction entre le silane et l'ammoniac, en atmosphère aussi exempte d'oxygène que possible.

Mais, dans diverses possibilités d'application de l'invention où des implantations ioniques supplémentaires sont nécessaires pour la formation d'éléments de circuit dans les caissons isolés obtenus par le procédé selon l'invention, il est possible de traiter thermiquement la plaquette à la fin des étapes d'implantation.

Ainsi, par exemple pour la réalisation de transistors de type JFET (pour "Junction field effect transistors"), il est nécessaire d'implanter un autre ion qui conduit à un type de conductivité inverse, par exemple du béryllium, pour le type de conductivité p. Dans ce cas, la détermination préalable de la concentration en porteurs libres permet de déterminer très précisément le flux d'implants et l'énergie de ceux-ci, spécialement dans le cas de transistors JFET, normalement bloqués, où la jonction est particulièrement profonde et les densités respectives des porteurs libres sont particulièrement difficiles à ajuster.

L'avantage de l'implantation du couple d'ions siliciumoxygène par rapport aux autres implants connus, destinés à rendre isolante la région implantée d'arséniure de gallium, tels que le bombardement de protons, est dû notamment au fait qu'il supporte des températures de recuit supérieures à 800°C, alors que cette propriété d'isolation obtenue par un bombardement de protons disparaît lors de recuit supérieur à 350°C.

Il est évident que de nombreuses variantes de l'invention peuvent être imaginées par l'homme de l'art, sans pour cela sortir du cadre de la présente invention telle que décrite ci-dessus et revendiquée ci-après.

### Revendications

1. Procédé de fabrication d'un dispositif semiconducteur comportant un corps semiconducteur en arséniure de gallium (GaAs), dans lequel un substrat semi-isolant d'arséniure de gallium est pourvu sur une face d'une couche d'arséniure de gallium de type de conductivité N, après quoi, des régions d'isolement sont formées, lesdites régions d'isolement s'étendant au moins jusqu'à la région du substrat semi-isolant et divisant ladite couche d'arséniure de gallium en des îlots mutuellement isolés, îlots dans lesquels des éléments de circuit semiconducteur sont formés, ladite couche d'arséniure de gallium de type de conductivité N étant formée par une implantation d'ions sur l'entière surface du substrat semi-isolant et lesdites régions d'isolement étant formées ensuite par une opération sélective, le corps semiconducteur étant soumis à un traitement thermique après l'implantation, caractérisé en ce que les ions de dopage de la couche N sont des ions de silicium, en ce que les régions d'isolement sont formées par implantation d'ions d'oxygène, et en ce que le traitement thermique a lieu après la formation des régions d'isolement.

2. Procédé selon la revendication 1, caractérisé en ce que ledit traitement thermique est conduit avec le corps semiconducteur recouvert d'une couche d'encapsulation.

3. Procédé selon la revendication 2, caractérisé en ce que ledit traitement thermique est conduit avec le corps semiconducteur recouvert d'une couche d'encapsulation de nitrure de silicium, à une température comprise sensiblement entre 700 et 900°C, durant approximativement 15 minutes, sous atmosphère d'azote.

4. Procédé selon l'une des revendications 1 à 3, caractérisé en ce que l'on réalise la première implantation d'ions silicium avec une dose comprise sensiblement entre $10^{12}$ et $5.10^{12}$ ions $\times$ $cm^{-2}$, et une énergie comprise entre 50 keV et 500 keV.

5. Procédé selon l'une des revendications 1 à 4, caractérisé en ce que l'on réalise la deuxième implantation d'ions oxygène avec une dose comprise sensiblement entre $10^{13}$ et $5.10^{13}$ ions $\times$ $cm^{-2}$ et une énergie comprise entre 50 keV et 500 keV.

### Patentansprüche

1. Verfahren zum Herstellen einer Halbleiteranordnung mit einem Halbleiterkörper aus Galliumarsenid (GaAs), in dem ein halbleitendes Substrat aus Galliumarsenid auf einer Fläche einer N-leitenden Galliumarsenidschicht vorgesehen ist, wonach Isoliergebiete gebildet werden, wobei diese Isoliergebiete sich bis wenigstens an das halbleitende Substrat erstrecken und die genannte Galliumarsenidschicht in gegenseitig isolierte Inseln aufteilen, wobei in diesen Inseln Halbleiterschaltungselemente gebildet werden, wobei die genannte N-leitende Galliumarsenidschicht durch eine Ionenimplantation über die ganze Oberfläche des halbleitenden Substrats gebildet wird und wobei die genannten Isoliergebiete daraufhin durch einen selektiven Vorgang gebildet werden, wobei der Halbleiterkörper nach der Implantation einer thermischen Behandlung ausgesetzt wird, dadurch gekennzeichnet, dass die Dotierungsionen der N-leitenden Schicht Siliziumionen sind, dass die Isoliergebiete durch Implantation von Sauerstoffionen gebildet werden und dass die thermische Behandlung nach der Bildung der Isoliergebiete erfolgt.

2. Verfahren nach Anspruch 1, dadurch gekennzeichnet, dass die genannte thermische Behandlung unter Umständen durchgeführt wird, bei denen der Halbleiterkörper mit einer Einkapselungsschicht bedeckt ist.

3. Verfahren nach Anspruch 2, dadurch gekennzeichnet, dass die genannte thermische Behandlung unter Umständen durchgeführt wird, bei denen der Halbleiterkörper mit einer Einkapselungsschicht aus Siliziumnitrid bedeckt ist und bei einer Temperatur, die im wesentlichen zwischen 700 und 900°C liegt, während etwa 15 Minuten in einer Stickstoffatmosphäre.

4. Verfahren nach einem der Ansprüche 1 bis 3, dadurch gekennzeichnet, dass die erste Implantation von Siliziumionen mit einer Dosis im wesentlichen zwischen $10^{12}$ und $5.10^{12}$ Ionen $\times$ $cm^{-2}$ und mit einer Energie zwischen 50 keV und 500 keV erfolgt.

5. Verfahren nach einem der Ansprüche 1 bis 4, dadurch gekennzeichnet, dass die zweite Implantation von Sauerstoffionen mit einer Dosis im wesentlichen zwischen $10^{13}$ und $5.10^{13}$ Ionen $\times$ $cm^{-2}$ und mit einer Energie zwischen 50 keV und 500 keV erfolgt.

### Claims

1. A method of making a semiconductor device comprising a semiconductor body of gallium arsenide (GaAs), in which on a surface of a semi-insulating substrate of gallium arsenide there is provided a layer of gallium arsenide of the N-conductivity type, after which isolation regions are formed, said isolating regions extending at least to the semi-insulating substrate region and dividing said layer of gallium arsenide into mutually isolated islands, in which semiconductor circuit elements are formed, said layer of gallium arsenide of the N-conductivity type being formed by an ion implantation throughout the surface of the semi-insulating substrate and said isolating regions being then formed by a selective operation, the semiconductor body being subjected to a thermal treatment after the implantation, characterized in that the doping ions of the N-layer are silicon ions, in that the isolating regions are formed by implantation of oxygen ions and in that a thermal treatment is carried out after the formation of the isolating regions.

2. A method as claimed in Claim 1, characterized in that said thermal treatment is carried out while the semiconductor body is covered with an encapsulation layer.

3. A method as claimed in Claim 2, characterized in that said thermal treatment is carried out while the semiconductor body is covered with an encapsulation layer of silicon nitride, at a temperature lying substantially between 700 and 900°C for about 15 minutes in a nitrogen atmosphere.

4. A method as claimed in any one of Claims 1 to 3, characterized in that the first implantation, of silicon ions, is carried out with a dose substantially between $10^{12}$ and $5.10^{12}$ ions $\times$ cm$^{-2}$ and an energy between 50 keV and 500 keV.

5. A method as claimed in any one of Claims 1 to 4 characterized in that the second implantation, of oxygen ions, is carried out with a dose substantially between $10^{13}$ and $5.10^{13}$ ions $\times$ cm$^{-2}$ and an energy between 50 keV and 500 keV.

0 075 368

FIG.1

$Si^+$

(n)

GaAs (SI)

FIG.2

$C^{-2}$
(u.a)

V

−6  −5  −4  −3  −2  −1  −0

FIG.3

1

N(x)
en
cm-3

$10^{18}$

$10^{14}$

$10^{16}$

$10^{15}$

LSS

0    0,1    0,2    0,3    0,4    x (μm)

**FIG.4**

11

12

**FIG.5**

$O^+$

12    11

I | n | I | n | I | n | I | n | I

10    Ga As ( SI )

**FIG.6**